# EUROPEAN PATENT APPLICATION

(11) **EP 4 382 575 A1**
(43) Date of publication of application: **12.06.2024**
(21) Application number: 22211580.0
(22) Date of filing: 06.12.2022
(51) Int. Cl.: C09C 1/30, B33Y 70/00, G03F 7/00, G03F 7/004, G03F 7/027

(54) **MILLED SILICA AND LIQUID RADIATION CURABLE COMPOSITIONS COMPRISING SAME**

(71) Applicant: Evonik Operations GmbH, 45128 Essen (DE)
(72) Inventor: MOO, James, 640260 Singapore (SG); KOBAYASHI, Hitoshi, 510-0211 Suzuka (JP); DEHE, Daniel, 63486 Bruchköbel (DE); MEYER, Jürgen, 63811 Stockstadt (DE)
(74) Representative: Evonik Patent Association

(57) **Abstract**

Fumed or precipitated silica milled in a first compressive milling step to a tapped density of 200 % - 1200 % of the initial tapped density of the fumed or precipitated silica and milled in a second expansive milling step to a tapped density of 10% to 50% of the tapped density after the first compressive milling step.

## Description

The present invention pertains to milled silica, radiation curable compositions comprising milled silica and their use in additive manufacturing applications.

Fumed silica has been recognized for use in liquid radiation curable formulations as rheology modifier. Concentration of the fumed silica in the formulation is commonly low due to thixotropic effects.

Precipitated silica has been used in tyre rubber to reduce roll resistance, as fillers in adhesives and sealants as a reinforcing filler and in silicone to increase tear resistance.

WO 2015189837 A1 describes a method of using hydrophilic fumed silica as a rheological modifier in photopolymers. However, the loading of the silica in the matrix is limited due to the viscosity increase with loading at 6-8 wt %.

US 20050040562 A1 describes the use of 10-50 nm colloidal silica particles for use in photoresins for 3D printing applications. The addition of silica increases hardness of the printed article but at the same time also increases brittleness and reduces elasticity.

US 20070205528 A1 discloses a 3D printing resin where a viscosity of 200 mPa.s is desired. This viscosity is achieved by adding colloidal silica nanoparticles to the resin. The addition of colloidal silica renders the resin easier to print but the toughness of the printed part will be greatly reduced.

US 20050040562 A1 discloses a 3D printing resin with a viscosity below 500 mPa.s. Silica colloidal nanoparticles are added to the resin to reduce the viscosity. The resin will be easier to print but the toughness of the printed part will also be greatly reduced.

US 6593393 B2 describes the use of fumed silica compressive milled by a ball mill for coating formulations. The compaction of the silica resulted in larger particle sizes. This achieves easy to disperse properties for the coating formulation but on the downside the larger particles settle faster in the coating formulation. US 6593393 B2 suggests a second optional milling step but is silent regarding the benefits of such an additional milling step for the coating formulation.

WO 2014098956 A1 describes the use of fumed silica surface functionalized with methacrylate groups as a filler for 3D printing resins to produce rigid dental polymers. The fumed silica reduces the porosity of the printed parts and increases the hardness of the polymer. This is achieved at the expense of elasticity and causes increased brittleness of the 3D printed material. As described in WO 2014098956 A1 the particle size of the silica is less than 60nm and the aggregate particle size is less than 200 nm.

It is an object of the present invention to provide milled silica and liquid radiation curable compositions comprising said milled silica that at least reduce the disadvantages of the prior art and to provide liquid radiation curable compositions that can produce articles with high toughness, good elasticity and reduced brittleness.

This object is achieved by a fumed or precipitated silica milled in a first compressive milling step to a mean tapped density of 200 % -1200 % of the initial tapped density of the fumed or precipitated silica and milled in a second expansive milling step to a mean tapped density of 10% to 50% of the mean tapped density after the first compressive milling step.

The order in which the fumed or precipitated silica is milled is essential for the invention. The first milling step is a compressive milling step followed by a second milling step which is an expansive milling step. The first compressive milling step forms larger particles and the second expansive step reduces the particle size again. Surprisingly it was found that the fumed or precipitated silica according to the invention can attain unique properties in printed three-dimensional objects when added to a liquid radiation curable composition for 3D printing. The printed objects exhibit high tensile toughness and at the same time high elongation at break.

The mean tapped density is measured according to DIN/ISO 787/11.

Fumed silica are spherical silica particles that are sintered at the neck to form longer chained fractal secondary structures. The hereforth mentioned milling process utilizing fumed silica can control the particle structures to be in the submicron range of 100 nm - 500 nm.

Precipitated silica is used in tyre rubber to reduce roll resistance, fillers in adhesives and sealants as a reinforcing filler and in silicone to increase tear resistance. Primary structures typically have a diameter of 5 nm - 100 nm.

Colloidal silica are spherical, discrete silica particles with a size less than 100 nm, mostly in the area of 20 nm - 60 nm and having no secondary fractal network structures. Due to the sphericity and non-porosity, colloidal silica is often selected as a filler to reduce porosity. However, colloidal silica provides little reinforcement to the mechanical properties.

Discrete colloidal silica is used as comparative example herein to differentiate the interconnected fumed silica's fractal network structures that can bring benefiting properties in improvement of tensile strength and stability within a polymer matrix.

Preferably the particle size of the milled fumed or precipitated silica according to the invention ranges from 100 nm - 500 nm.

Fine particles of colloidal silica are usually preferred in the art as the small particle size results in lower viscosities of 3D printing photopolymer compositions. Surprisingly, the fumed silica particles according to the invention attains superior properties as compared with the fine particles of colloidal silica.

Unexpectedly, the larger particle sizes of fumed silica, preferably in the range of 100 nm - 500 nm, can attain better properties in radiation curable compositions than colloidal silica if the particles are subjected to a two step milling process according to the invention.

Fumed or precipitated silica treated in a compressive milling and subsequent expansive milling step leads to unexpected new properties when used in liquid radiation curable compositions.

The tapped density and surface area suggest a return to the original non-milled material. Surprisingly new properties are achieved that have a beneficial effect on the mechanical properties of cured photopolymer resins. Using the fumed or precipitated silica according to the invention makes it possible to retain the toughness without sacrificing elasticity and without producing a brittle material.

Preferably the fumed or precipitated silica according to the invention is characterized in that it is milled in a first compressive milling step to a tapped density of 200 % - 800 % of the initial tapped density of the starting material and the thus milled fumed or precipitated silica is then milled in a second expansive milling step to a tapped density of 10% to 30% of the tapped density after the first compressive milling step.

The first compressive milling step is preferably carried out using a ball mill, hammer mill or impact mill more preferably with a ball mill. The second expansive milling step is preferably carried out using an air jet mill or a pin mill. In the air jet mill jets of fluids compressed to a gauge pressure ranging between 2 bar and 20 bar are used at a material flow between 2 and 500 kg/h.

The fumed or precipitated silica according to the invention preferably has a tapped density of 20 - 100 g/l, more preferably 20 - 80 g/l and most preferably 20 - 60 g/l.

Preferably the fumed or precipitated silica according to the invention is surface modified with a silane, organo-modified silane, silicone, organo-modified silicone or mixtures thereof.

More preferably the fumed or precipitated silica according to the invention is surface modified with an organo-modified silane selected from the group consisting of (meth)acrylate silane, epoxy silane and hexamethyldisilane.

Most preferably the milled silica according to the invention is a fumed silica. The fumed silica is preferably surface modified with an organo-modified silane selected from the group consisting of (meth)acrylate silane, epoxy silane and hexamethyldisilane.

The use of the fumed or precipitated silica according to the invention allows the application of larger sized particles in the range of 100 nm - 500 nm and it leads to outstanding performances for additive manufacturing. The prior art teaches use of smaller particles with a size of less than 60 nm (US 20050040562 A1) but the printed parts suffer from a drop in toughness. Surprisingly, the silica according to the invention reduces the loss of toughness in the printed article despite it being larger particles.

Without wishing to be bound by theory it is believed that the expansive milling step enables easy dispersing of the silica into a radiation curable resin with lower number of agglomerates, while the compressive milling step enables a reduction in the viscosity of the resin without losing the beneficial effect of the expansive milling step.

Radiation curable resins containing silica according to the invention have lower viscosity than resins without the silica according to the invention. The addition of fumed or precipitated silica according to the invention enables low settling rates coupled with increases in Ultimate Tensile Strength and tensile modulus while maintaining the toughness of printed radiation cured three dimensional articles.

Thus, the present invention also pertains to a liquid radiation curable composition comprising fumed or precipitated silica according to the invention in a concentration of 5 wt% - 50 wt% of the total liquid curable composition. More preferably the liquid radiation curable composition comprising fumed or precipitated silica according to the invention in a concentration of 5 wt% - 25 wt% of the total liquid curable composition and most preferably 5 wt% - 15 wt%.

In general, the unexpected effect of the milled fumed or precipitated silica according to the invention can be achieved in all liquid curable compositions.

Preferably the liquid curable composition comprises reactive oligomers selected from the group consisting of (meth)acrylate, ethoxylated (meth)acrylate, urethane (meth)acrylate, epoxy, epoxy (meth)acrylate, bisphenol ethoxylate (meth)acrylate, polyester (meth)acrylate, thiol-ene, silicone (meth)acrylate, unsaturated polyesters, polyether (meth)acrylates, unsaturated polyurea, phenolic polymers, organosilicon, cyclic carbonate (meth)acrylates, hyperbranched propenoic acid ester, pure acrylate, organic silicon acrylic ester, acryl (meth)acrylates, vinyl ester, polysiloxane (meth)acrylates, amidimide, poly(ethylene glycol), mercaptan-functionalized polysiloxane, vinyl-terminated poly-(dimethylsiloxane), epoxy aliphatic (meth)acrylates, polycarbonate (meth)acrylates. More preferably the liquid curable composition comprises reactive oligomers selected from epoxy, (meth)acrylate, ethoxylated (meth)acrylate, epoxy (meth)acrylate, bisphenol ethoxylate (meth)acrylate or urethane (meth)acrylate, polyester (meth)acrylate, bisphenol (meth)acrylate.

The liquid curable composition also comprises reactive monomers selected from the group consisting of (meth)acrylates and epoxy or mixtures thereof.

The liquid radiation curable composition according to the invention preferably comprises Component a) 40 wt% - 80 wt% of one or more reactive oligomer(s) selected from the group consisting of epoxy, (meth)acrylate, ethoxylated (meth)acrylate, epoxy (meth)acrylate, bisphenol ethoxylate (meth)acrylate or urethane (meth)acrylate, polyester (meth)acrylate, bisphenol (meth)acrylate.
Component b) 20 wt% - 90 wt% of one or more reactive monomer(s) selected from (meth)acrylates and epoxy;
Component c) 5 wt% - 50 wt% fumed or precipitated silica milled in a first compressive milling step to a tapped density of 200 % -1200 % of the initial tapped density of the fumed or precipitated silica and milled in a second expansive milling step to a tapped density of 10% to 50% of the tapped density after the first compressive milling step.
Component d) 0 wt% -15 wt% crosslinker having reactivity to component a) and/or b); Component e) 0.01 wt% to 10 wt % of one or more photoinitiator(s);
Component f) 0 wt % -20 wt % of one or more additives selected from the group consisting of pigments, fillers, dispersant(s), defoamer(s), antioxidant(s), light stabilizer(s), light absorber(s) or radical inhibitor(s);
provided that the sum of all components equals 100 %.

As used herein oligomer means intermediate of a polymerization reaction that involves two or more units.

The term "(meth)acrylate" means either a methacrylate, an acrylate or a mixture of both.

Reactive means that components a) and b) can form multiple polymeric crosslinked networks with itself, each other or with component d) in the presence of radicals, anions, nucleophiles or combinations thereof.

Crosslinkers are molecules that create a bond or short sequence of bonds that connect one polymer chain to another polymer chain. These links may take the form of ionic or more commonly covalent bonds. Common crosslinkers in photopolymers are difunctional, trifunctional or quadrofunctional such as dipropyleneglycol diacrylate, 1,6-Hexanediol diacrylate, trimethylolpropane triacrylate, trimethylolpropane ethoxylate triacrylate and propoxylated pentaerythritol tetraacrylate.

Photoinitiators are molecules that absorb photons upon irradiation with light and form reactive species which initiate cascade reactions. Suitable photoinitiators include bis-acyl-phosphine-oxide, diphenyl(2,4,6-trimethylbenzoyl)phosphine oxide or benzophenone.

The liquid radiation curable composition according to the invention is especially suitable to be used in additive manufacturing processes especially in VAT photopolymerization processes. Such additive manufacturing processes usually comprise the repeated steps of deposition or layering and irradiating the composition to form a three-dimensional object.

Additive manufacturing (AM) technology through a photopolymerization process in which layer-by-layer solidification of liquid resinous materials by means of radiation curing (e.g. UV) to manufacture three-dimensional solid polymeric objects has tremendous potential for direct manufacturing of end-use parts.

Thus, the invention also encompasses the use of the liquid radiation curable composition according to the invention in an additive manufacturing process that comprises the repeated steps of deposition or layering and irradiating the composition to form a three-dimensional object.

The additive manufacturing process is preferably DLP-digital light processing, SLA-stereolithography, FFD-fused filament deposition or material jetting.

As mentioned above it was unexpectedly found that the liquid radiation curable composition can attain printed three-dimensional objects with unique properties having high tensile toughness and at the same time high elongation at break.

The invention also encompasses a three-dimensional object formed by an additive manufacturing process using a liquid radiation curable composition containing the fumed or precipitated silica according to the invention.

### EXAMPLES

### Example 1

Fumed silica is synthesized by the flame hydrolysis method in which silicon tetrachloride reacts with hydrogen and oxygen. The resulting fumed silica has a surface area of 200 m²/g determined according to ISO 9277. The mean tapped density of the fumed silica was 55 g/L. Mean tapped density was measured according to DIN/ISO 787/11.

This fumed silica with a surface area of 200 m²/g and a tapped density of approximately 50 g/L was mixed with 4 parts water and 18 parts 3-methacryloxypropyltrimethoxysilane and the mixture was heat-treated at 140° C under an inert gas. The silica obtained is designated as Type1 and has the properties as shown in Table 1. The surface area of the particles is reduced after surface modification due to adhesion of the particles from the moisture content and thereby the exposed surface becomes smaller.

### Example 2:

The fumed silica of Example 1 with a mean tapped density of 55 g/l was milled with an air jet mill to a tapped density of 16 g/L. Air jet milling is an expansive milling step. Milling of the fumed silica was carried out in a single milling step. The fumed silica thus obtained is designated as Type2 and has the properties as shown in Table 1.

### Example 3:

The fumed silica of Example 1 with a mean tapped density of 55 g/l was compacted to a tapped density of 197 g/l using a continuously operating vertical ball mill. Milling with a vertical ball mill is a compressive milling step. Milling of the fumed silica was carried out in a single milling step. The silica thus obtained is designated as Type 3 and has the properties as shown in Table 1.

### Example 4:

The fumed silica of Example 1 with a mean tapped density of 55 g/l was compacted in a first compressive milling step to a tapped density of approx. 200 g/l using a continuously operating vertical ball mill. In a second step the material from the first milling step was re-milled in an expansive milling step with an air jet mill to a mean tapped density of 42 g/L. The silica obtained is designated as Type 4 and has the properties as shown in Table 1.

**Table 1: Properties of the fumed silica types of Examples 1 to 4**

| Fumed Silica Type | **Type 1** | **Type 2** | **Type 3** | **Type 4** |
|---|---|---|---|---|
| Surface Modification | Methacrylate-silane | Methacrylate-silane | Methacrylate-silane | Methacrylate-silane |
| Vertical Ball Milling | no | no | yes | yes |
| Air jet Milling | no | yes | no | yes |
| Surface Area (m²/g) | 147 | 157 | 155 | 156 |
| Carbon Content [%] | 5.5 | 5.5 | 5.5 | 5.3 |
| Tapped density [g/l] | 55 | 16 | 197 | 42 |
| DOA (ml/100g) | 217 | 202 | 130 | 173 |
| Particle size [nm] | 575 | 325 | 666 | 326 |

The surface area (m²/g) was measured according to ISO 9277.

Carbon content was determined ISO-3262-20.

The tapped density was measured according to DIN / ISO 787/11

The oil absorbtion number DOA (ml/100g) was measured according to ISO 19246.

The particle size was determined as Z-average in ethanol using dynamic light scattering according to ISO 22412.

The non-milled surface modified silica Type 1 has a particle size Z-average (ISO 22412) of 575 nm. The air jet milled silica Type 2 has a particle size of 325 nm. A compressive milling step in example 3 resulted in Type 3 with a particle size Z-average of 666 nm. With a compaction and expansive remilling step, a particle size of 326 nm is reached in Type 4.

The tapped density of the non-milled surface modified silica Type 1 material was increased to from 55 g7l to 197 g/l I Type 3 before reducing the tapped density to 42 g/mL in Type 4 which is in a similar range as the tapped density of the non-milled surface modified silica Type 1 at 55 g/mL.

While the tapped density and surface area are similar in Type 1 and Type 4, the particle sizes in ethanol are very different. The particle size of the non-milled Type 1 was 575 nm and the particle size of the two-step milled Type 4 was 326 nm.

Very surprisingly the examples show that using silica that was milled in an expansive and a compressive milling step can improve the printability and strength of photopolymer resins without sacrificing elasticity.

### Example 5

A 3D printable radiation curable composition containing 79 wt. % isobornyl acrylate, 20 wt. % bisphenol ethoxylate dimethacrylate and 1 wt. % bis acyl phosphine oxide was prepared. Fumed Silica Types 1 - 4 were added to that resin in a concentration of 10 wt. % and mixed in a speedmixer at 3000 rpm for 5 min.

A colloidal silica designated as Type 5 was used to prepare a resin with 10 wt. % of Type 5 in the same way.

Colloidal silica is a dispersion of synthetic amorphous nanoscale silica particles in a reactive diluent, often used as a filler in polymers. The colloidal silica used for example 5 had a particle size Z average of 20 nm and a surface area of 140 m²/g. The surface area (m²/g) was measured according to ISO 9277.

**Table 2: Properties of resins containing various types of silica particles**

| Resin | 0 | 1 | 2 | 3 | 4 | 5 |
|---|---|---|---|---|---|---|
| Silica type | NA | Type 1 | Type 2 | Type 3 | Type 4 | Type 5 |
| Silica content [wt.%] | 0 | 10 | 10 | 10 | 10 | 10 |
| Grindometer fineness [µm] | 1 | 47 | 12 | 47 | 11 | 0 |
| Viscosity [mPa.s] | 20 | 835 | 700 | 52 | 107 | 21 |
| Settling rate [mm/year] | NA | 1 | 13 | 268 | 147 | 94 |

Grindometer with a depth range of 50 micrometer was used in accordance with DIN ISO 1524 to check for the fineness of the particles [µm] in the resin.

Viscosity of the resin in [mPa.s] was determined according to ISO 3219.

Settling rate in [mm/year] was determined according to ISO/TR 13097. Settling rates of less than 200 mm/year are required for a resin to qualify as stable.

Resin 1 containing silica Type 1 has a very low settling rate of 1 mm/year but Resin 1 is not printable because of the high viscosity of 835 mPa.s.

Resin 2 containing silica Type 2 also has a low settling rate but the viscosity is too high and thus the resin is unsuitable for 3D printing.

Resin 3 containing silica Type 3 has a high settling rate of 268 mm/year which renders the resin as not stable enough for commercial use.

Resin 4 containing silica Type 4 that was milled with a two step milling combining compressive milling and expansive milling exhibits a settling rate of 147 mm/year which means the resin is stable and suitable for commercial use. Resin 4 also exhibits a very low viscosity of 107 mPa.s and it is therefore suitable for 3D printing even at room temperature.

Resin 5 containing 10 wt.% of silica Type 5 (colloidal silica) is also stable with a settling rate of 94 mm/year and very low viscosity of 21 mPa.s that allows use in 3D printing applications.

The Grindometer fineness is an indication of the number of particle agglomerates. The dispersing quality of a photopolymer resin is checked by means of Grindometer fineness with a 50 µm gauge in accordance with ISO 1524.

The Grindometer fineness must be smaller than 15 µm to be used in a 3D printable photopolymer resin. Grindometer fineness above 15 µm can lead to visible silica agglomerates in the 3D printed part which means the visual as well as mechanical properties of the 3D printed part are impaired. The expansive milling step reduces the settling rate of the samples. Resin 4 containing silica Type 4 which underwent an expansive milling step followed by a compressive milling step has a much lower settling rate per year in the accelerated aging test as compared to resin 3 containing Type 3 silica which only underwent compressive milling. The settling rate of resin 4 is comparable to resin 5 containing colloidal silica which is the most common silica used.

Resins 1 and 2 have lowest settling speeds but such resins are unsuitable for 3D printing applications due to the higher viscosities of the silica in the resin at 835 mPa.s and 700 mPa.s respectively.

### Example 6

For Example 6 the same 3D printable radiation curable composition as shown in Example 5 containing 79 wt. % isobornyl acrylate, 20 wt. % bisphenol ethoxylate dimethacrylate and 1 wt. % bis acyl phosphine oxide.

Fumed Silica Types 1 - 4 were added to that resin in a concentration of 10 wt. % and mixed in a speedmixer at 3000 rpm for 5 min. A colloidal silica designated as Type 5 was used to prepare a resin with 10 wt. % of Type 5 in the same way.

Resins 0 to 5 were printed in a masked stereolithographic 3D printer with 1.0 mW/cm⁻² and a 30 s exposure time for each 100 µm deposited layer.

Printed specimens were produced according to ASTM D638 Type V bars.

Mechanical properties of the printed specimens are shown in table 3 below.

**Table 3: Mechanical properties of printed bars using Resin 0 to 5**

| Resin | 0 | 1 | 2 | 3 | 4 | 5 |
|---|---|---|---|---|---|---|
| Silica type | NA | Type 1 | Type 2 | Type 3 | Type 4 | Type 5 |
| Silica content [wt%] | None | | | | | |
| UTS [MPa] | 26 | 31 | 32 | 33 | 30 | 29 |
| Elongation at break [%] | 133 | 79 | 91 | 38 | 94 | 62 |
| Tensile modulus [MPa] | 1379 | 1788 | 1781 | 1861 | 1789 | 1548 |
| Toughness [MPa] | 25 | 19 | 23 | 8.9 | 21 | 12 |

The Ultimate Tensile Strength (UTS) in [MPa] was determined according to ASTM D638.

The Elongation at break in [%] was determined according to ASTM D638

The Tensile Modulus in [MPa] was determined according to ASTM D638.

The Toughness in [MPa] was determined according to ASTM D638.

Resin 0 does not contain any silica particles. In the absence of silica in Resin 0, the UTS of the printed Type V bar was found to be 26 MPa. The elongation at break according to ASTM D638 was 133%, the tensile modulus was 1379 MPa and the toughness was found to be 25 MPa.

For Resin 1 containing 10 wt% of fumed silica Type 1 the mechanical properties could only be determined if after every printing layer resin was pushed to the center of the photopolymer VAT. Due to the high viscosity of the resin it did not flow. Resin 1 is not suitable for use as 3D printing resin at room temperature. The mechanical properties in Table 3 are for reference only.

For Resin 2 containing 10 wt% of fumed silica Type 2 which was treated with an expansive milling step the situation was similar as it was for Resin 1. The mechanical properties could only be determined after every layer resin was pushed to the center of the photopolymer VAT because Resin 2 also did not flow due to its high viscosity. Resin 2 is also not suitable for use as 3D printing resin. For Resin 1 and Resin 2 the printer needed to be paused to push the material manually into the printer. The mechanical properties in Table 3 are for reference only.

Resin 3 contained 10 wt% of fumed silica Type 3 which was treated with a compressive milling step. The viscosity of the resin made it suitable for 3D printing. However, the settling rate is too high to be used as a commercial resin. Mechanical properties of the printed bar show an UTS of 33 MPa which is in a similar range as the other resins. The elongation at break decreases to 38 % as compared to 91 % of Resin 2. The tensile modulus of the printed bar was determined to be 1861 MPa with a toughness of 8.9 MPa. The toughness is significantly lower than printed bars from Resin 0 or Resin 4.

Resin 4 contained 10 wt% of fumed silica Type 4 which was treated in an expansive and a compressive milling step. Using Resin 4 to print the Type V bar recovers the elongation at break to 94 % from 38 % using printed Resin 3.

Comparing the properties of the printed bar from Resin 5 containing 10 wt% of colloidal silica Type 5 with Resin 4 it can be shown that Resin 5 has a slightly lower UTS at 29 MPa, a significantly lower tensile modulus at 1548 MPa and also a significantly lower elongation at break at 62% vs 94 % for Resin 4. Toughness is 42 % lower and was found to be 12 MPa.

Colloidal silica was used as it has been used in applications to improve tensile modulus (US20050040562A1). As can be seen in example 6, Resin 4 containing silica Type 4 has a higher performance of tensile modulus at 1789 MPa than colloidal silica at 1548 MPa in Resin 5.

Ultimate Tensile Strength (UTS) measured using Type V bars according to ASTM D638 is improved from 26 MPa in Resin 0 to 30 MPa using Resin 4. Elongation at break is reduced but still higher than in Resins 1, 2, 3 and 5 especially compared with Resin 3 where the elongation at break deteriorated to 38 %.

Resin 4 containing fumed silica Type 4 according to the invention can significantly improve the ultimate tensile strength UTS while largely retaining the Toughness of the material after printing.

Very surprisingly the examples show that using silica that was milled in a compressive and an expansive milling step can improve the printability and strength of photopolymer resins without sacrificing elasticity.

Photopolymer resins containing silica according to the invention lower the viscosity of the resin and enable low settling rates coupled with increases in UTS and tensile modulus while maintaining the toughness.

Fumed silica treated in a compressive milling and subsequent expansive milling step leads to unexpected new properties when used in photopolymer resin. The tapped density and surface area suggest a return to the original non-milled material. Surprisingly new properties are achieved that have a beneficial effect on the mechanical properties of cured photopolymer resins.

## Claims

1. Fumed or precipitated silica milled in a first compressive milling step to a tapped density of 200 % -1200 % of the initial tapped density of the fumed or precipitated silica and milled in a second expansive milling step to a tapped density of 10% to 50% of the tapped density after the first compressive milling step.

2. Fumed or precipitated silica according to claim 1, **characterized in that** the fumed or precipitated silica is milled in a first compressive milling step to a tapped density of 200 % - 800 % of the initial tapped density of the starting material and the milled in a second expansive milling step to a tapped density of 10% to 30% of the tapped density after the first compressive milling step.

3. Fumed or precipitated silica according to claim 1 or 2, **characterized in that** the first compressive milling step is carried out in a ball mill, hammer mill or impact mill and the second expansive milling step is carried out in an air jet mill or a pin mill.

4. Fumed or precipitated silica according to any one of claims 1 to 3, **characterized in that** the tapped density of the milled silica is 20 - 100 g/l.

5. Fumed or precipitated silica according to any one of claims 1 to 4, **characterized in that** the fumed or precipitated silica is surface modified with a silane, organo-modified silane, silicone, organo-modified silicone or mixtures thereof.

6. Fumed or precipitated silica according to claim 5, **characterized in that** the fumed or precipitated silica is surface modified with an organo-modified silane selected from the group consisting of (meth)acrylate silane, epoxy silane and hexamethyldisilane.

7. Liquid radiation curable composition comprising fumed or precipitated silica according to any one of claims 1 to 6 in a concentration of 5 wt% - 50 wt% of the total liquid curable composition.

8. Liquid radiation curable composition according to claim 7 comprising
Component a) 40 wt% - 80 wt% of one or more reactive oligomer(s) selected from the group consisting of epoxy, (meth)acrylate, ethoxylated (meth)acrylate, epoxy (meth)acrylate, bisphenol ethoxylate (meth)acrylate or urethane (meth)acrylate, polyester (meth)acrylate and bisphenol (meth)acrylate;
Component b) 20 wt% - 90 wt% of one or more reactive monomer(s) selected from (meth)acrylates and epoxy;
Component c) 5 wt% - 50 wt% fumed or precipitated silica according to any one of claims 1 to 6;
Component d) 0 wt% -15 wt% crosslinker having reactivity to component a) and/or b);
Component e) 0.01 wt% to 10 wt % of one or more photoinitiator(s);
Component f) 0 wt % -20 wt % of one or more additives selected from the group consisting of pigments, fillers, dispersant(s), defoamer(s), antioxidant(s), light stabilizer(s), light absorber(s) or radical inhibitor(s);
provided that the sum of all components equals 100 %

9. Use of the liquid radiation curable composition according to claim 7 or 8 in an additive manufacturing process that comprises the repeated steps of deposition or layering and irradiating the composition to form a three-dimensional object.

10. A three-dimensional object formed by an additive manufacturing process using a liquid radiation curable composition according to claim 7 or 8.
